# FASCICULE DE BREVET EUROPEEN

(11) **EP 0 578 555 B1**
(45) Date de publication et mention de la délivrance du brevet: **22.01.1997**
(21) Numéro de dépôt: 93401738.5
(22) Date de dépôt: 05.07.1993
(51) Int. Cl.: H03K 17/691, H03K 17/61, H02M 7/5387

(54) **Convertisseur commandé par impulsions et commande électronique de moteur**
Pulsgesteuerter Umwandler und elektronische Motorsteuerung
Pulse-controlled converter and electronic motor control

(30) Priorité: 10.07.1992 FR 9208637
(43) Date de publication de la demande: 12.01.1994
(73) Titulaire: SGS-THOMSON MICROELECTRONICS, 94253 Gentilly Cédex (FR)
(72) Inventeur: Bourgeois, Jean-Marie, c/o SGS-THOMSON, Schaumburg, IL 60173 (US)
(74) Mandataire: Michelet, Alain

(56) Documents cités:
- EP-A- 0 486 359
- GB-A- 2 109 184

## Description

L'invention concerne un convertisseur de puissance commandé par impulsions, sa commande associée, et une commande de moteur électrique mettant en oeuvre de tels convertisseurs.

Par exemple, les commandes électroniques de moteurs électriques utilisent de tels convertisseurs, mettant en oeuvre des interrupteurs électroniques de puissance en configuration bras de pont ou pont complet.

Les moteurs électriques à commande électronique sont susceptibles de nombreuses applications. Toutefois, jusqu'à présent, le développement de certaines d'entre elles est freiné par le coût des convertisseurs.

En effet, les composants de puissance nécessaires restaient, jusqu'à ces dernières années, relativement coûteux à mettre en oeuvre.

Depuis quelque temps, des transistors de puissance MOSFET sont disponibles et permettent la réalisation de convertisseurs courant continu/courant alternatif de bonne qualité. Leur facilité de mise en oeuvre les rend particulièrement attractifs.

Par ailleurs, on connaît déjà des convertisseurs commandés par un système numérique.

Ils comportent un niveau basse tension (étage bas des bras de pont), dont la réalisation ne présente pas de difficulté particulière. L'unité de contrôle numérique peut être associée à un amplificateur de puissance, par exemple MOSFET.

Par contre, la réalisation du circuit haute tension (étage haut des bras de pont) est plus délicate en raison de la différence de potentiel existant entre la commande de grille et l'unité de contrôle numérique.

Différentes solutions ont été proposées pour réaliser ce circuit.

Selon la première d'entre elles, on met en oeuvre des circuits intégrés haute tension, éventuellement associés à des composants intégrés standard. Toutefois, le coût de ces circuits intégrés haute tension est relativement élevé et ne devrait pas sensiblement diminuer dans les années à venir. De plus, de tels dispositifs nécessitent des circuits complémentaires, tels que des alimentations auxiliaires flottantes, nécessaires pour leur fonctionnement.

Une autre solution consiste à utiliser un petit transformateur haute fréquence placé entre chaque circuit de commande de grille du MOSFET et l'unité de contrôle numérique. Le circuit primaire de ce transformateur est commandé par un signal haute fréquence, le circuit secondaire comporte un circuit particulier permettant l'actionnement de la grille du composant MOSFET de puissance.

Enfin, selon une troisième solution, on utilise la capacité d'entrée du composant MOSFET de puissance comme une mémoire à l'état passant. La mémoire à l'état bloqué met en oeuvre une capacité auxiliaire. Le transformateur d'impulsions ne nécessite ici que quelques spires.

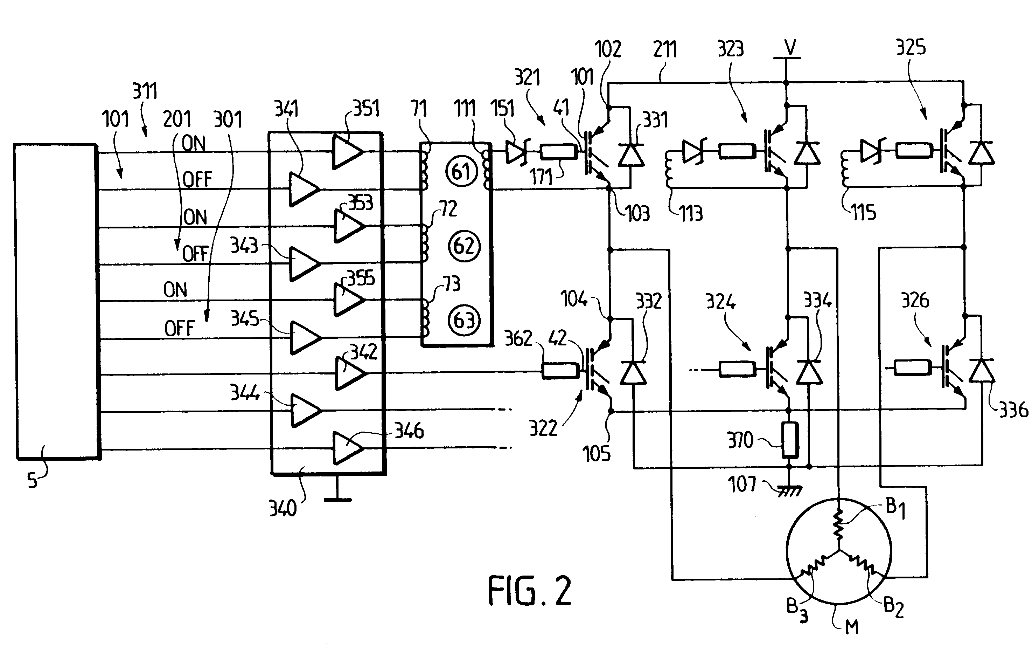

Le document GB-A-2.109.184 décrit un montage de commande à liaison par transformateur pour effectuer des niveaux de conduction alternés par commutation. Dans l'un des modes de réalisation présentés (Figure 5), le montage comporte deux générateurs d'impulsions de commande agissant, respectivement sur deux interrupteurs par le biais de transformateurs. Des diodes zener sont interposées entre les transformateurs et les interrupteurs, et les générateurs d'impulsions doivent être synchronisés. Dans un autre mode de réalisation (Figure 2b), un montage de diodes zener est interposé entre le secondaire d'un transformateur et la grille d'un interrupteur.

Le document EP-A-0.486.359 propose quant à lui un circuit de commande de commutation d'un transistor à effet de champ de type MOS ou d'un transistor bipolaire à grille isolée (IGBT). Ce document montre, en particulier, un circuit de seuil comportant des diodes zener, en série avec une résistance, disposées entre l'enroulement secondaire d'un transformateur impulsionnel et la grille d'un interrupteur (Figure 6). La présence de capacités parasites entre la grille et la source du transistor permet de maintenir le transistor conducteur ou bloqué suite à des impulsions positives ou négatives.

Ce circuit repose donc sur le comportement des capacités parasites.

Le but de la présente invention est la réalisation d'un convertisseur commandé par impulsions de synchronisation adéquate aussi simple que possible, c'est-à-dire dont le prix puisse être très faible.

Pour atteindre cet objectif, on a considéré qu'il est souhaitable et possible d'attribuer un grand nombre de fonctionnalités à l'unité de contrôle numérique et de ne laisser au circuit haute tension qu'une fonction très simple.

L'invention concerne donc un convertisseur commandé par impulsions comprenant au moins un premier interrupteur statique, situé à l'étage haut d'un bras de pont, interrompant périodiquement un courant continu, et un deuxième interrupteur, à l'étage bas dudit bras de pont, ledit premier interrupteur étant commandé par des impulsions appliquées à sa grille.

Ces impulsions sont produites par une unité de contrôle numérique reliée à la grille du premier interrupteur par un transformateur d'impulsions.

Ce transformateur a un enroulement primaire connecté à l'unité de contrôle numérique par un circuit "BUFFER", et un enroulement secondaire relié à la grille du premier interrupteur par un circuit secondaire simplifié.

Le deuxième interrupteur est directement commandé par l'unité de contrôle numérique.

Le premier interrupteur est tel que lorsqu'il est à l'état ouvert, une impulsion positive lui étant adressée au travers du transformateur associé par l'unité de contrôle numérique provoque sa fermeture, et que lorsqu'il est à l'état fermé, une impulsion négative provoque son ouverture.

Selon l'invention et dans un mode de réalisation préféré, le circuit secondaire ne comporte qu'une diode zener et une résistance placées en série entre une première borne de l'enroulement secondaire et la grille.

De plus, une séquence appropriée de commande génère une impulsion négative adressée au premier interrupteur, au travers du transformateur associé, lorsque ledit premier interrupteur est ouvert, et chaque fois que tout autre interrupteur du convertisseur est commuté à l'état fermé ou ouvert, lesdites impulsions étant parfaitement synchronisées avec la commutation desdits autres interrupteurs.

Selon différents modes de réalisation possibles, le premier interrupteur comporte un transistor de puissance MOSFET à canal - N -, ou un transistor bipolaire à électrode isolée (IGBT).

Dans un mode de réalisation possible, le circuit secondaire comporte un condensateur placé en parallèle entre la diode zener et la résistance d'une part, et la deuxième borne de l'enroulement secondaire d'autre part. Une diode est alors placée en parallèle sur la résistance.

Le circuit primaire comporte avantageusement un adaptateur de courant et tension dit "BUFFER" interfaçant l'unité de contrôle numérique avec le transformateur d'impulsions.

Ledit convertisseur comporte un deuxième interrupteur, référencé au même potentiel que l'unité de contrôle numérique, et pouvant de ce fait être commandé directement sans transformateur d'isolement.

Lorsque ce convertisseur comporte plusieurs bras de pont, une même unité de contrôle numérique peut être utilisée pour produire les impulsions de commande et contrôle du convertisseur.

Lorsque le circuit de commande électronique est destiné à des moteurs à courants alternatifs, et qu'il comporte trois convertisseurs montés en pont, chaque premier interrupteur est avantageusement commandé par des impulsions positives produisant sa fermeture, et par des impulsions négatives produisant son ouverture.

On obtient un circuit de commande particulièrement intéressant lorsque des impulsions négatives sont adressées par l'unité de commande numérique, à chaque premier interrupteur à l'état ouvert, au travers du transformateur associé lors de la fermeture de chacun des autres premiers interrupteurs.

De préférence, chaque convertisseur est associé à un deuxième interrupteur, sans effet mémoire, directement commandé par un amplificateur relié à l'unité de commande numérique.

Une telle configuration matérielle ne peut fonctionner sans une judicieuse séquence de commande des différents interrupteurs, objet de la présente invention.

Afin d'expliciter l'invention, un mode de réalisation donné, à titre d'exemple non limitatif, sera décrit en détail, en référence aux dessins annexés, dans lesquels :
- la Figure 1 est une représentation schématique d'un convertisseur selon l'invention ;
- la Figure 2 est une représentation schématique d'une commande électronique de moteur à courants alternatifs selon l'invention ;
- la Figure 3 est une représentation des formes d'onde de commande des interrupteurs représentés sur la Figure 2.

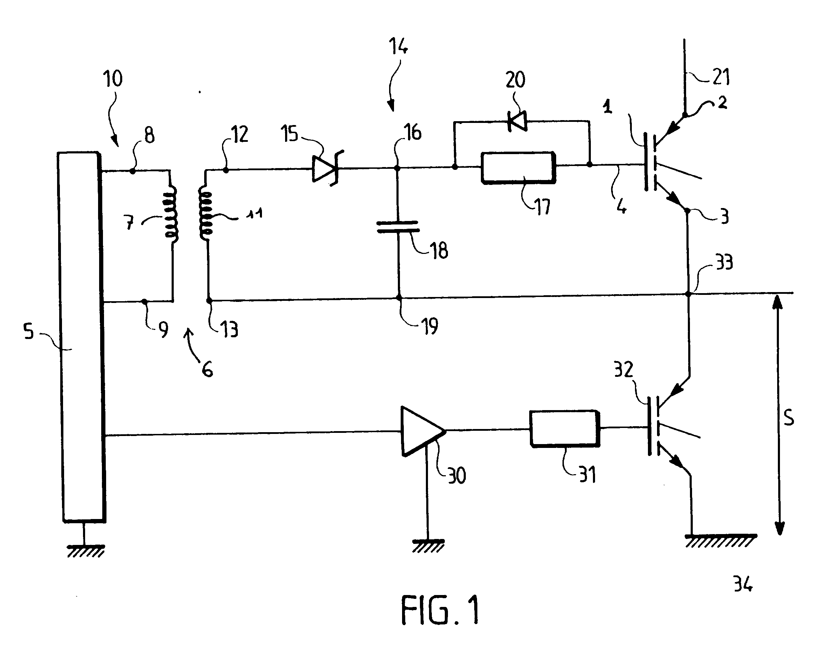

Le convertisseur de courant, représenté sur la Figure 1, comporte un premier interrupteur statique 1, interposé par ses bornes 2 et 3 sur le conducteur de courant 21. L'état de ce premier interrupteur 1, ouvert ou fermé, est commandé par action sur sa grille 4.

Un circuit secondaire 14, reliant la borne 4 de la grille à la borne 3 du premier interrupteur 1, assure sa commande. Il comporte un enroulement secondaire 11, formant avec un enroulement primaire 7, un transformateur 6.

L'enroulement primaire 7 reçoit par ses bornes 8 et 9 les impulsions produites par l'unité de contrôle numérique 5, avec laquelle il forme le circuit primaire 10.

Ce circuit primaire 10 peut comporter un amplificateur.

Le circuit secondaire 14 comporte une diode zener 15 et une résistance 17, placées en série entre une borne 12 de l'enroulement secondaire 11 et la grille 4 du premier interrupteur 1.

La deuxième borne 13 de l'enroulement secondaire 11 est reliée à la borne 3 du premier interrupteur 1.

Le transformateur 6, destiné à recevoir des impulsions, peut être réalisé à faible coût, le primaire 7 et le secondaire 11 ne comportant chacun que quelques spires enroulées sur un petit noyau.

Ce transformateur isole le circuit primaire 10 comportant l'unité de contrôle numérique 5 du circuit secondaire 14.

Le circuit secondaire est extrêmement simple. Une impulsion positive produite par l'unité de contrôle numérique 5, adressée au circuit secondaire au travers du transformateur 6, place le premier interrupteur 1 en l'état fermé. Au contraire, une impulsion négative le place en l'état ouvert.

Un deuxième interrupteur 32 est directement commandé par l'unité de contrôle numérique 5 au travers de l'organe tampon (BUFFER) 30. Il est à l'état fermé lorsqu'il reçoit une tension non nulle, et à l'état ouvert lorsque cette tension est nulle.

Le courant de sortie du convertisseur est prélevé entre la borne 33, commune aux interrupteurs 1 et 32, et la terre 34.

La génération convenable de la séquence de commande de l'unité de contrôle numérique 5 permet ainsi le contrôle d'un courant de puissance, dont les principaux paramètres peuvent être aisément contrôlés dans le conducteur 21.

Par nature, le premier interrupteur 1 est vu par le circuit secondaire comme présentant une capacité naturelle placée entre la borne 4 de la grille 2 et la borne 3 du premier interrupteur 1. Cette capacité naturelle maintient l'état fermé du premier interrupteur, lorsqu'il est activé par une impulsion positive, et jusqu'à réception d'une impulsion négative.

Dans certaines réalisations, il est souhaitable de retarder la fermeture du premier interrupteur.

A cet effet, une capacité 18 est placée entre la borne 16, commune à la diode zener 15 et à la résistance 17, et une borne 19 reliée directement à la deuxième borne 13 de l'enroulement secondaire 11 et à la borne 3 du premier interrupteur 1. De plus, une diode 20 est placée en parallèle sur la résistance 17 entre la borne 4 de la grille et la borne 16, en sens opposé à la diode zener 15.

Ainsi, une impulsion positive produite par l'unité de contrôle numérique 5 produit la charge de la capacité 18 par un courant traversant la diode zener en mode direct.

La résistance 17 limite le courant de charge et détermine le moment du basculement du premier interrupteur 1 par rapport à l'impulsion.

La capacité 18 sert alors de maintien à l'état passant, puisque la diode zener est alors polarisée en inverse et maintient le courant sur la grille 4.

Inversement, une impulsion négative émise par l'unité de contrôle numérique 5, compensant la tension zener, produit la décharge de la capacité 18 et de la capacité d'entrée, et donc l'ouverture du premier interrupteur 1.

Le second interrupteur 32 est référencé au même potentiel que le circuit de contrôle et peut être commandé directement par un BUFFER 30 à travers une résistance 31.

Une telle configuration matérielle ne peut fonctionner sans une judicieuse séquence de commande des différents interrupteurs, objet de la présente invention.
a) La séquence de commutation du premier interrupteur est la suivante :
   - une impulsion positive de tension est appliquée au primaire du transformateur, chargeant de ce fait la capacité d'entrée du premier interrupteur à travers la résistance et la diode, rendant l'interrupteur conducteur ;
   - consécutivement, les charges sont maintenues dans la capacité de grille de l'interrupteur grâce à la diode zener, gardant l'interrupteur conducteur ;
   - une impulsion négative de tension appliquée au primaire du transformateur et correspondant à la tension de la diode zener, va décharger la capacité d'entrée du premier interrupteur et le bloquer.
b) Une impulsion positive doit être appliquée :
   - chaque fois que le premier interrupteur doit être commuté de l'état ouvert à l'état fermé ;
   - pour rafraîchir la charge de sa capacité d'entrée, lorsque la durée de l'état fermé est importante.
c) Une impulsion négative doit être appliquée :
   - chaque fois que le premier interrupteur doit être commuté de l'état fermé à l'état ouvert ;
   - lorsque le premier interrupteur étant à l'état ouvert, le deuxième interrupteur ou tout autre interrupteur du convertisseur, est commuté à l'état fermé ou ouvert, et ceci de façon parfaitement synchrone.

On a représenté sur la Figure 2 le schéma d'une commande électronique de moteur électrique à courants alternatifs, conforme à l'invention.

Trois circuits secondaires 321, 323, 325 sont chacun commandés par l'unité de contrôle numérique 5 au travers des transformateurs 61, 62, 63. Par commodité, seul l'enroulement secondaire 111 a été représenté en face de l'enroulement primaire correspondant 71. Il faut comprendre que, dans la réalisation concrète, les secondaires 113 et 115 seront respectivement associés aux primaires 72 et 73.

Les composants de ces différents circuits secondaires sont identiques, et seul le circuit 321 sera décrit, les autres s'en déduisant sans difficulté.

Une diode zener 151 est placée en série avec une résistance 171 entre l'une des bornes de l'enroulement secondaire 111 et la grille 41 du premier interrupteur 101. Les bornes 102 et 103 du premier interrupteur 101 sont placées sur la ligne de courant 211. Une diode 331 est placée entre ces bornes 102 et 103, en parallèle sur le premier interrupteur.

Le circuit primaire 311 est relié à une unité de contrôle numérique 5 par l'intermédiaire de deux amplificateurs 341 et 351. Les circuits secondaires 313 et 315 sont de même nature et comportent les amplificateurs, respectivement 343, 353, 345, 355.

Trois autres interrupteurs, respectivement 322, 324, 326 dits "seconds interrupteurs", sont chacun associés à l'un des premiers interrupteurs. Ils ont une borne 104 associée à la borne 103 du premier interrupteur 101 correspondant, et leur deuxième borne 105 est associée au travers du composant 370 à la terre. La haute tension V est établie entre la borne 102 et la terre 107. La grille 42 de l'interrupteur 322 est reliée par l'intermédiaire d'une résistance 362 et d'un amplificateur 342 à une unité de contrôle numérique 5. Les interrupteurs 324 et 326 sont montés de la même manière et reliés aux amplificateurs 344 et 346.

Des diodes 332, 334, 336 sont chacune placées entre la borne 104 du deuxième interrupteur, commune avec la borne 103 du premier et la terre.

Chacune des bobines B1, B2, B3 du moteur est reliée par l'une de ses bornes à la borne commune au premier et au deuxième interrupteurs 103-104.

Les premiers interrupteurs sont commandés par des impulsions positives et négatives, et les circuits secondaires conservent la mémoire de l'état fermé engendré par une impulsion positive jusqu'à réception d'une impulsion négative.

Les deuxièmes interrupteurs 322, 324, 326 sont directement commandés. Ils sont à l'état fermé, lorsqu'ils reçoivent une tension non nulle, commandée par l'unité de contrôle numérique 5 au travers des amplificateurs 342, 344, 346, et sont à l'état ouvert, lorsqu'ils reçoivent une tension nulle.

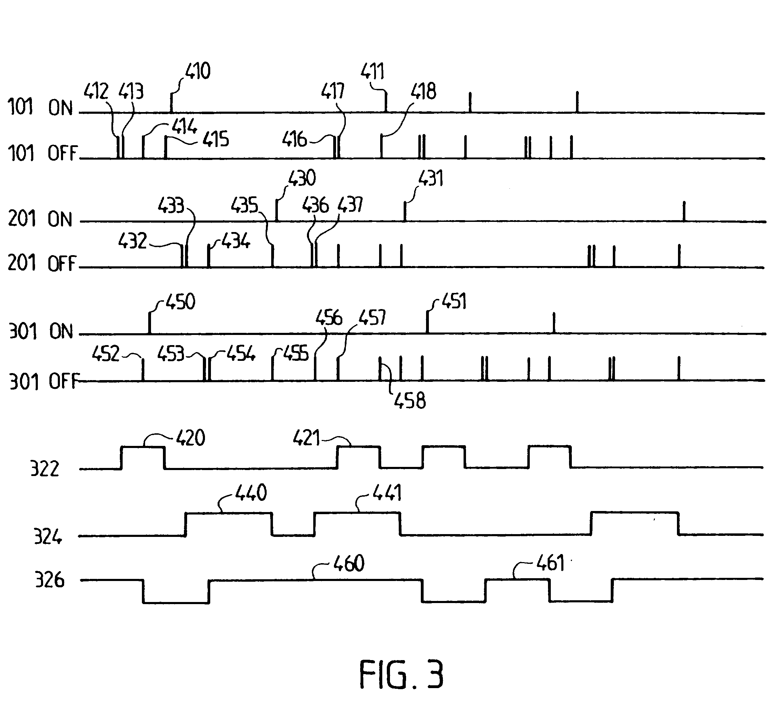

Les séquences de commande de chaque couple d'interrupteurs 101/322, 201/324, 301/326 sont analogues les unes aux autres, et sont représentées sur la Figure 3.

Pour le couple 101/322 :

La séquence 101 de commutation du premier interrupteur est la suivante.
a) Une impulsion positive 410 de tension est appliquée au primaire du transformateur, chargeant de ce fait la capacité d'entrée du premier interrupteur à travers la résistance et la diode, rendant l'interrupteur conducteur.
   Une impulsion positive est donc appliquée :
   - chaque fois que le premier interrupteur doit être commuté de l'état ouvert à l'état fermé (par exemple en 410-411),
   - pour rafraîchir la charge de sa capacité d'entrée, lorsque la durée de l'état fermé est importante (non représenté ici).
b) Consécutivement, les charges sont maintenues dans la capacité de grille de l'interrupteur grâce à la diode zener, gardant l'interrupteur conducteur.
c) Une impulsion négative de tension 412-416 appliquée au primaire du transformateur et correspondant à la tension de la diode zener, va décharger la capacité d'entrée du premier interrupteur et le bloquer.

Une impulsion négative est donc appliquée :
- chaque fois que le premier interrupteur doit être commuté de l'état fermé à l'état ouvert (par exemple en 412 et 416),
- lorsque le premier interrupteur étant à l'état ouvert, le deuxième interrupteur ou tout autre interrupteur du convertisseur, est commuté à l'état fermé ou ouvert, et ceci de façon parfaitement synchrone (par exemple en 413-414-415).

La séquence 322 indique les commutateurs du deuxième interrupteur 31.

Pour le couple 201/324 :

La séquence de commutation 201 du premier interrupteur est la suivante.
a) Une impulsion positive 430 de tension est appliquée au primaire du transformateur, chargeant de ce fait la capacité d'entrée du premier interrupteur à travers la résistance et la diode, rendant l'interrupteur conducteur.
   Une impulsion positive est donc appliquée :
   - chaque fois que le premier interrupteur doit être commuté de l'état ouvert à l'état fermé (par exemple en 430-431),
   - pour rafraîchir la charge de sa capacité d'entrée, lorsque la durée de l'état fermé est importante (non représenté ici).
b) Consécutivement, les charges sont maintenues dans la capacité de grille de l'interrupteur grâce à la diode zener, gardant l'interrupteur conducteur.
c) Une impulsion négative de tension 436 appliquée au primaire du transformateur et correspondant à la tension de la diode zener, va décharger la capacité d'entrée du premier interrupteur et le bloquer.

Une impulsion négative est donc appliquée :
- chaque fois que le premier interrupteur doit être commuté de l'état fermé à l'état ouvert (par exemple en 432-436),
- lorsque le premier interrupteur étant à l'état ouvert, le deuxième interrupteur ou tout autre interrupteur du convertisseur, est commuté à l'état fermé ou ouvert, et ceci de façon parfaitement synchrone (par exemple en 433-434-435-437)

Pour le couple 301/326 :

La séquence de commutation 301 du premier interrupteur est la suivante.
a) Une impulsion positive de tension 450 est appliquée au primaire du transformateur, chargeant de ce fait la capacité d'entrée du premier interrupteur à travers la résistance et la diode, rendant l'interrupteur conducteur.
   Une impulsion positive est donc appliquée :
   - chaque fois que le premier interrupteur doit être commuté de l'état ouvert à l'état fermé (par exemple en 450-451),
   - pour rafraîchir la charge de sa capacité d'entrée, lorsque la durée de l'état fermé est importante (non représenté ici).
b) Consécutivement, les charges sont maintenues dans la capacité de grille de l'interrupteur grâce à la diode zener, gardant l'interrupteur conducteur.
c) Une impulsion négative de tension 453 appliquée au primaire du transformateur et correspondant à la tension de la diode zener, va décharger la capacité d'entrée du premier interrupteur et le bloquer.

Une impulsion négative est donc appliquée :
- chaque fois que le premier interrupteur doit être commuté de l'état fermé à l'état ouvert (par exemple en 452-453),
- lorsque le premier interrupteur étant à l'état ouvert, le deuxième interrupteur ou tout autre interrupteur du convertisseur, est commuté à l'état fermé ou ouvert, et ceci de façon parfaitement synchrone (par exemple en 454-455-456-457-458).

Les signes de référence, insérés après les caractéristiques techniques mentionnées dans les revendications, ont pour seul but de faciliter la compréhension de ces dernières, et n'en limitent aucunement la portée.

## Revendications

1. Convertisseur commandé par impulsions comprenant au moins un premier interrupteur statique (1, 101), situé à l'étage haut d'un bras de pont, interrompant périodiquement un courant continu pour réguler ledit courant, et au moins un deuxième interrupteur, situé à l'étage bas d'un bras de pont,
ledit premier interrupteur (1, 101) étant commandé par des impulsions appliquées à sa grille (4),
lesdites impulsions étant produites par une unité de contrôle numérique (5) reliée à la grille (4) du premier interrupteur (1) par un transformateur (6, 61), ayant un enroulement primaire (7, 71) connecté à l'unité de contrôle numérique (5) par un circuit primaire (10, 340), et un enroulement secondaire (11, 111) relié à la grille (4) du premier interrupteur (1) par un circuit secondaire (14),
le deuxième interrupteur étant directement commandé par l'unité de contrôle numérique (5),
le premier interrupteur (1, 101) étant tel que lorsqu'il est à l'état ouvert, une impulsion positive lui étant adressée au travers du transformateur associé (6) par l'unité de contrôle numérique (5) provoque sa fermeture, et que lorsqu'il est à l'état fermé, une impulsion négative provoque son ouverture,
caractérisé en ce que le circuit secondaire (14) comporte une diode zener (15, 151) et une résistance (17, 171) placées en série entre une première borne (12) de l'enroulement secondaire (11) et la grille (4) du premier interrupteur (1,101), et en ce que l'unité de contrôle numérique (5) génère une séquence appropriée de commande avec une impulsion négative adressée au premier interrupteur, au travers du transformateur associé, ceci lorsque ledit premier interrupteur est ouvert, et ceci chaque fois que tout autre interrupteur du convertisseur est commuté à l'état fermé ou ouvert, lesdites impulsions étant parfaitement synchronisées avec la commutation desdits autres interrupteurs.

2. Convertisseur commandé par impulsions selon la revendication 1, caractérisé en ce que le premier interrupteur comporte un transistor de puissance MOSFET à canal - N -.

3. Convertisseur commandé par impulsions selon la revendication 1, caractérisé en ce que le premier interrupteur comporte un transistor bipolaire à électrode isolée ou IGBT.

4. Convertisseur commandé par impulsions selon l'une quelconque des revendications 1 à 3, caractérisé en ce que le circuit secondaire comporte un condensateur (18) placé en parallèle entre le point de connexion entre la diode zener et la résistance d'une part, et la deuxième borne de l'enroulement secondaire d'autre part, et une diode (20) placée en parallèle sur la résistance.

5. Convertisseur commandé par impulsions selon l'une quelconque des revendications 1 à 4, caractérisé en ce que le circuit primaire comporte un organe tampon ou buffer (340).

6. Circuit de commande électronique de moteur électrique comprenant au moins un convertisseur selon l'une quelconque des revendications 1 à 5.

7. Circuit de commande électronique de moteur selon la revendication 6, caractérisé en ce qu'une même unité de contrôle numérique produit les impulsions.

8. Circuit de commande électronique de moteur à courants alternatifs selon l'une des revendications 6 et 7, caractérisé en ce qu'il comporte trois convertisseurs montés en pont, et en ce que chaque premier interrupteur est commandé par des impulsions positives produisant sa fermeture, et par des impulsions négatives produisant son ouverture.

9. Circuit de commande électronique de moteur selon la revendication 8, caractérisé en ce que des impulsions négatives sont adressées par l'unité de contrôle numérique à chaque premier interrupteur à l'état ouvert au travers du transformateur associé lors de la fermeture de chacun des autres premiers interrupteurs.

10. Circuit de commande électronique de moteur selon l'une quelconque des revendications 8 et 9, caractérisé en ce que chaque convertisseur est associé à un deuxième interrupteur, sans effet mémoire, directement commandé par un amplificateur relié à l'unité de contrôle numérique.

## Patentansprüche

1. Impulsgesteuerter Wandler mit wenigstens einem in der hohen Stufe eines Brükkenzweigs befindlichen statischen Schalter (1, 101), der einen Gleichstrom periodisch unterbricht, um diesen Strom zu regeln, und mit wenigstens einem zweiten Schalter, der in der tiefen Stufe eines Brückenzweigs angeordnet ist,
- wobei der erste Schalter (1, 101) durch an sein Gatter (4) angelegte Impulse gesteuert ist,
- wobei die Impulse durch eine digitale Steuereinheit (5) erzeugt werden, die mit dem Gatter (4) des ersten Schalters (1) über einen Transformator (6, 61) verbunden ist, welcher eine Primärwicklung (7, 71), die mit der digitalen Steuereinheit (5) über eine erste Schaltung (10, 340) verbunden ist, und eine Sekundärwicklung (11, 111),
die mit dem Gatter (4) des ersten Schalters (1) über eine zweite Schaltung (14) verbunden ist, aufweist,
- wobei der zweite Schalter direkt von der digitalen Steuereinheit (5) gesteuert wird,
- wobei der erste Schalter (1, 101) derart ausgebildet ist, daß, im offenen Zustand, ein von der digitalen Steuereinheit (5) an ihn über den zugehörigen Transformator (6) angelegter positiver Impuls das Schließen des Schalters bewirkt, und daß, wenn sich der Schalter im geschlossenen Zustand befindet, ein negativer Impuls das Öffnen des Schalters bewirkt,
dadurch gekennzeichnet, daß die zweite Schaltung (14) eine Zener-Diode (15, 151) und einen Widerstand (17, 171) aufweist, die seriell zwischen einem ersten Anschluß (12) der Sekundärwicklung (11) und dem Gatter (4) des ersten Schalters (1, 101) angeordnet sind, und daß die digitale Steuereinheit (5) eine geeignete Steuersequenz mit einem über den zugehörigen Transformator an den ersten Schalter gerichteten negativen Impuls erzeugt, wenn der erste Schalter offen ist, und dies jedes Mal, wenn jeder andere Schalter des Wandlers in den geschlossenen oder offenen Zustand gesteuert wird, wobei die Impulse mit der Umschaltung der anderen Schalter vollkommen synchronisiert sind.

2. Impulsgesteuerter Wandler nach Anspruch 1, dadurch gekennzeichnet, daß der erste Schalter einen n-Kanal-MOSFET-Leistungstransistor aufweist.

3. Impulsgesteuerter Wandler nach Anspruch 1, dadurch gekennzeichnet, daß der erste Schalter einen Bipolartransistor mit isolierter Elektrode, oder IGBT, aufweist.

4. Impulsgesteuerter Wandler nach einem der Ansprüche 1 bis 3, dadurch gekennzeichnet, daß die zweite Schaltung einen Kondensator (18), der parallel zwischen dem Verbindungspunkt zwischen der Zener-Diode und dem Widerstand, einerseits, und dem zweiten Anschluß der Sekundärwicklung, andererseits, angeordnet ist, und eine Diode (20) aufweist, die parallel zum Widerstand angeordnet ist.

5. Impulsgesteuerter Wandler nach einem der Ansprüche 1 bis 4, dadurch gekennzeichnet, daß die erste Schaltung ein Dämpfungsorgan oder einen Puffer (340) aufweist.

6. Elektronische Steuerschaltung eines Elektromotors, mit wenigstens einem Wandler nach einem der Ansprüche 1 bis 5.

7. Elektronische Steuerschaltung für einen Motor nach Anspruch 6, dadurch gekennzeichnet, daß dieselbe digitale Steuereinheit die Impulse erzeugt.

8. Elektronische Steuerschaltung für einen Wechselstrommotor nach einem der Ansprüche 6 und 7, dadurch gekennzeichnet, daß sie drei in Brückenform angeordnete Wandler aufweist, und daß jeder erste Schalter durch positive Impulse, welche das Schließen desselben bewirken, und durch negative Impulse, welche das Öffnen desselben bewirken, gesteuert wird,

9. Elektronische Steuerschaltung für einen Motor nach Anspruch 8, dadurch gekennzeichnet, daß die digitale Steuereinheit beim Schließen jedes anderen ersten Schalters negative Impulse an jeden im offenen Zustand befindlichen ersten Schalter über den zugehörigen Transformator sendet.

10. Elektronische Steuerschaltung für einen Motor nach einem der Ansprüche 8 und 9, dadurch gekennzeichnet, daß jeder Wandler einem zweiten Schalter ohne Speichereffekt zugeordnet ist, welcher direkt von einem mit der digitalen Steuereinheit verbundenen Verstärker gesteuert wird.

## Claims

1. Pulse-controlled converter comprising at least one first solid-state switch (1, 101) located in the upper stage of a bridge arm, periodically interrupting a dc current to regulate said current, and at least one second switch, located in the lower stage of a bridge arm,
said first switch (1, 101) being controlled by pulses applied to its gate (4),
said pulses being produced by a digital control unit (5) linked to the gate (4) of the first switch (1) via a pulse transformer (6, 61), having one primary winding (7, 71) connected to the digital control unit (5) via a primary circuit (10, 340) and a secondary winding (11, 111) linked to the gate (4) of the first switch (1) via a secondary circuit (14),
the second switch being directly controlled by the digital control unit (5),
the first switch (1, 101) being such that when it is in an open state, a positive pulse provided through the associated transformer (6) by the digital control unit (5) involves the closure of said first switch and when it is in a closed state, a negative pulse involves the opening of said first switch,
characterized in that the secondary circuit (14) comprises a Zener diode (15, 151) and a resistor (17, 171) which are connected in series between a first terminal (12) of the secondary winding (11) and the gate (4) of the first switch (1, 101) and in that the digital control unit (5) generates an appropriate control sequence with a negative pulse that is sent to the first switch, via the associated transformer, when the said first switch is open, and whenever any other switch of the converter is switched to the closed or open state, said pulses being perfectly synchronized with the switching of said other switches.

2. Pulse-controlled converter according to Claim 1, characterized in that the first switch comprises an N-channel MOSFET power transistor.

3. Pulse-controlled converter according to Claim 1, characterized in that the first switch comprises an isolated electrode bipolar transistor or IGBT.

4. Pulse-controlled converter according to any one of Claims 1 to 3, characterized in that the secondary circuit comprises a capacitor (18) mounted in parallel between the junction point of the Zener diode and the resistor on the one hand, and the second terminal of the secondary winding on the other hand, and a diode (20) mounted in parallel across the resistor.

5. Pulse-controlled converter according to any one of Claims 1 to 4, characterized in that the primary circuit comprises a buffer device or buffer (340).

6. Electronic electric motor controller comprising at least one converter according to any one of claims 1 to 5.

7. Electronic motor controller according to Claim 6, characterized in that the pulses are produced by a single digital control unit.

8. Electronic controller for ac motors according to one of Claims 6 and 7, characterized in that it comprises three converters mounted in a bridge configuration, and in that each first switch is controlled by positive pulses that close it and by negative pulses that open it.

9. Electronic motor controller according to Claim 8, characterized in that the digital control unit sends negative pulses to each first switch in the open state, via the associated transformer, whenever each of the other first switches close.

10. Electronic motor controller according to any one of Claims 8 and 9, characterized in that each converter is associated with a second switch, without memory effect, which is directly controlled by an amplifier linked to the digital control unit.
